(19) Europäisches Patentamt / European Patent Office / Office européen des brevets

(11)  **EP 4 382 922 B1**

(12)  **EUROPEAN PATENT SPECIFICATION**

(45) Date of publication and mention
of the grant of the patent:
**25.06.2025  Bulletin 2025/26**

(21) Application number: **23205548.3**

(22) Date of filing: **24.10.2023**

(51) International Patent Classification (IPC):
**G01R 19/165** (2006.01)  **G01R 31/396** (2019.01)

(52) Cooperative Patent Classification (CPC):
**G01R 31/396; G01R 19/16542**

(54)  **MEASURING DEVICE, DIAGNOSTIC SYSTEM INCLUDING THE SAME, AND DIAGNOSTIC METHOD USING THE SAME**

MESSVORRICHTUNG, DIAGNOSESYSTEM DAMIT UND DIAGNOSEVERFAHREN DAMIT

DISPOSITIF DE MESURE, SYSTÈME DE DIAGNOSTIC LE COMPRENANT ET PROCÉDÉ DE DIAGNOSTIC L'UTILISANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **06.12.2022  KR 20220169003**

(43) Date of publication of application:
**12.06.2024  Bulletin 2024/24**

(73) Proprietor: **Samsung SDI Co., Ltd.**
**Yongin-si, Gyeonggi-do 17084 (KR)**

(72) Inventor: **PARK, Songyi**
**Yongin-si (KR)**

(74) Representative: **Marks & Clerk LLP**
**15 Fetter Lane**
**London EC4A 1BW (GB)**

(56) References cited:
**CN-A- 109 541 489      KR-A- 20190 042 340**
**KR-A- 20200 107 813      US-A1- 2016 291 114**
**US-A1- 2020 200 805**

**Description**

## BACKGROUND OF THE DISCLOSURE

**(a) Field of the Disclosure**

The present disclosure relates to a measuring device, a diagnostic system including the same, and a diagnostic method using the same.

**(b) Description of the Related Art**

In a battery system, a battery management system (BMS) may be divided into several modes according to a cycle of measuring a voltage, a current, a temperature, and the like.

The measuring cycle of the BMS may be used as an indicator for diagnosing whether the BMS is normally operating. However, in order to check the measuring cycle of the BMS, efforts such as displaying a specific signal on a screen by using equipment such as an oscilloscope and manipulating the screen and the equipment are required, and the work therefor may take excessive time.

Korean Patent Application Publication KR20200107813A relates to a battery management system diagnosis method executed by a battery management system controlling and inspecting a battery module. The method includes: a first step of determining whether or not a battery management system is abnormal by comparing a first condition of a battery, which is calculated through a first algorithm determining a battery condition by using at least one first element among the voltage, temperature and current of the battery, to a second condition of the battery, which is calculated through a second algorithm determining a battery condition by using an element different from the first element; and a second step of determining whether or not the battery management system is abnormal by determining whether or not the process of calculating the second condition of the battery through the second algorithm is normally operated if the first condition and the second condition are equal.

United States Patent Application Publication US2020/200805A1 relates to an electrical current measurement circuit. The electrical current measurement circuit is configured to receive a sense current proportionally related to an electrical current of interest to continuously charge a capacitor to a sense voltage. The electrical current measurement circuit is configured to determine whether the sense voltage reaches a predefined voltage threshold and reduce the sense voltage to below the predefined voltage threshold in response to the sense voltage reaching the predefined voltage threshold. The electrical current measurement circuit counts each occurrence of the sense voltage reaching the predefined voltage threshold and quantifies the electrical current based on a total count of the sense voltage reaching the predefined voltage threshold during the predefined measurement period.

Chinese Patent Application Publication CN109541489A relates to a battery pack diagnostic apparatus including a communication port, a measurer, and a controller. The communication port provides an electrical connection between the battery pack diagnostic apparatus and a battery management system. The measurer is electrically connected to an output terminal of the battery pack and is configured to measure a voltage and a current of the battery pack. The controller is configured to obtain a first measurement value with respect to a voltage and a current of the battery pack from the battery management system. The controller is further configured to obtain a second measurement value with respect to a second voltage and a second current of the battery pack from the measurer. The controller analyzes a state of the battery pack based on the first measurement value and the second measurement value.

Korean Patent Application Publication KR20190042340 relates to a system for diagnosing a state of a battery pack. The system for diagnosing a state of a battery pack is configured to comprise: an on board charger receiving power from an external charging device and converting the received power into a power for charging a battery pack to charge the battery pack; and a battery management system monitoring a state of the battery pack and diagnosing the state of the battery pack through control of the on board charger.

United States Patent Application Publication US2016/291114A1 relates to a method for detecting a malfunction of a battery control system including a plurality of sensors intended to measure separate physical quantities of the battery, the method including the following steps: a) reading output values of the sensors; and b) determining, by means of a processing unit, whether the read values are consistent with a physical phenomenon conditioning relationships between at least two of the quantities.

## SUMMARY OF THE DISCLOSURE

The present disclosure has been made in an effort to provide a measuring device that may check a measuring cycle of a BMS.

The present disclosure has been made in an effort to provide a diagnostic system and a diagnostic method that may diagnose whether a BMS is normally operating according to a measuring cycle of the BMS.

An embodiment provides a measuring device, including: a voltage measurer measuring a voltage from a node on a wire connected to a battery management system (BMS); and a controller that receives the measured voltage signal from the voltage measurer to derive a voltage value, counts the number of times the voltage value reaches a reference voltage during a measuring period, and determines a state of the BMS as one of a normal state of a first mode, a normal state of a second mode, and an abnormal state based on the number of times.

The wire may be a wire connected to one end of a thermistor. The first mode is a power mode in which the BMS measures a temperature from the thermistor at a cycle of a first period. The second mode is a power mode in which the BMS measures the temperature from the thermistor at a cycle of a second period longer than the first period.

When the number of times is within a first range in which a value obtained by dividing the measuring period by the first period and multiplied by 2 is a minimum value and a value obtained by adding 2 to the minimum value is a maximum value, the controller may determine the state of the BMS as the normal state of the first mode.

When the number of times is within a second range in which a value obtained by dividing the measuring period by the second period and multiplied by 2 is a minimum value and a value obtained by adding 2 to the minimum value is a maximum value, the controller may determine the state of the BMS as the normal state of the second mode.

The controller may determine the state of the BMS as the abnormal state when the number is not within the first and second ranges.

Another embodiment provides a diagnostic system, including: a measuring device that measures a voltage from a node on a wire connected to a battery management system (BMS), derives a voltage value from the measured voltage signal, counts the number of times the voltage value reaches a reference voltage during a measuring period, and determines a state of the BMS as one of a normal state of a first mode, a normal state of a second mode, and an abnormal state based on the number of times; and an output device that receives a signal indicating the state of the BMS from the measuring device, and outputs a diagnostic result including the state of the BMS based on the signal indicating the state of the BMS.

The wire may be a wire connected to one end of a thermistor. The first mode is a power mode in which the BMS measures a temperature from the thermistor at a cycle of a first period. The second mode is a power mode in which the BMS measures the temperature from the thermistor at a cycle of a second period longer than the first period.

When the number of times is within a first range in which a value obtained by dividing the measuring period by the first period and multiplied by 2 is a minimum value and a value obtained by adding 2 to the minimum value is a maximum value, the measuring device may determine the state of the BMS as the normal state of the first mode.

When the number of times is within a second range in which a value obtained by dividing the measuring period by the second period and multiplied by 2 is a minimum value and a value obtained by adding 2 to the minimum value is a maximum value, the measuring device may determine the state of the BMS as the normal state of the second mode.

The measuring device may determine the state of the BMS as the abnormal state when the number is not within the first and second ranges.

The output device may include a display that visually outputs the diagnostic result.

Another embodiment provides a diagnostic method, including: measuring a voltage from a node on a wire connected to a battery management system (BMS); deriving a voltage value based on the measured voltage and counting the number of times the voltage value reaches a reference voltage during a measuring period; determining whether the number of times is within a first or second range; and determining the state of the BMS as one of a normal state of a first mode, a normal state of a second mode, and an abnormal state based on the determined result.

The wire may be a wire connected to one end of a thermistor. The first mode is a power mode in which the BMS measures a temperature from the thermistor at a cycle of a first period. The second mode is a power mode in which the BMS measures the temperature from the thermistor at a cycle of a second period longer than the first period.

The first range may be a range in which a value obtained by dividing the measuring period by the first period and multiplied by 2 is a minimum value and a value obtained by adding 2 to the minimum value is a maximum value.

The determining of the state of the BMS as one of the normal state of the first mode, the normal state of the second mode, and the abnormal state: may include determining, when the number of times is within the first range, the state of the BMS as the normal state of the first mode.

The second range may be a range in which a value obtained by dividing the measuring period by the second period and multiplied by 2 is a minimum value and a value obtained by adding 2 to the minimum value is a maximum value.

The determining of the state of the BMS as one of the normal state of the first mode, the normal state of the second mode, and the abnormal state: may include determining, when the number of times is within the second range, the state of the BMS as the normal state of the second mode.

The determining of the state of the BMS as one of the normal state of the first mode, the normal state of the second mode, and the abnormal state may include determining the state of the BMS as the abnormal state when the number is not within the first and second ranges.

The diagnostic method may further include outputting a diagnostic result including the state of the BMS determined as one of the normal state of the first mode, the normal state of the second mode, and the abnormal state.

The outputting of the diagnostic result may include visually outputting the state of the BMS and the number of times through a display.

According to the present disclosure, it is possible to diagnose whether a BMS normally operates by checking a measuring cycle of the BMS.

According to the present disclosure, it is possible to improve accuracy of mode determination by determining a power mode of a BMS based on a measuring cycle of the BMS.

At least some of the above and other features of the invention are set out in the claims.

## BRIEF DESCRIPTION OF THE DRAWINGS

FIG. 1 illustrates a block diagram of a diagnostic system according to an embodiment.

FIG. 2 is a block diagram for explaining a battery system to which a voltage measurer of FIG. 1 is connected.

FIG. 3 illustrates a flowchart of a diagnostic method according to an embodiment.

FIG. 4 and FIG. 5 illustrate waveform diagrams of voltage signals derived by a controller in step S2 of FIG. 3.

## DETAILED DESCRIPTION OF THE EMBODIMENTS

Hereinafter, embodiments disclosed in the present specification will be described in detail with reference to the accompanying drawings, and in the present specification, the same or similar constituent elements will be denoted by the same or similar reference numerals, and a redundant description thereof will be omitted. The terms "module" and/or "unit, portion, or part" representing constituent element used in the following description are used only in order to make understanding of the specification easier, and thus, these terms do not have meanings or roles that distinguish them from each other by themselves. In addition, in describing embodiments of the present specification, when it is determined that a detailed description of the well-known art associated with the present disclosure may obscure the gist of the present disclosure, it will be omitted. Further, the accompanying drawings are provided only in order to allow embodiments disclosed in the present specification to be easily understood and are not to be interpreted as limiting the present specification, and it is to be understood that the present disclosure includes all modifications, equivalents, and substitutions without departing from the scope of the present disclosure.

Terms including ordinal numbers such as first, second, and the like will be used only to describe various constituent elements, and are not to be interpreted as limiting these constituent elements. The terms are only used to differentiate one constituent element from other constituent elements.

In the present application, it should be understood that the term "include", "comprise", "have", or "configure" indicates that a feature, a number, a step, an operation, a constituent element, a part, or a combination thereof described in the specification is present, but does not exclude a possibility of presence or addition of one or more other features, numbers, steps, operations, constituent elements, parts, or combinations, in advance.

A program implemented as a set of instructions embodying a control algorithm necessary for controlling another component may be installed in a component for controlling another component under a specific control condition among components according to an embodiment. A control component may generate output data by processing input data and stored data according to the installed program. The control component may include a non-volatile memory for storing a program and a memory for storing data.

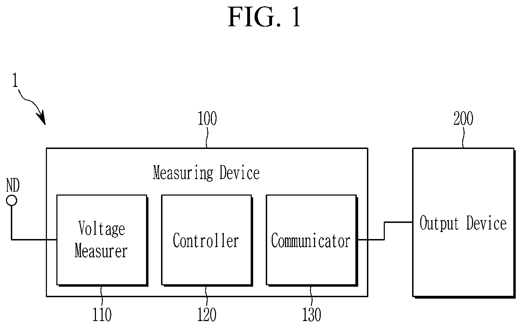

FIG. 1 illustrates a block diagram of a diagnostic system according to an embodiment.

Referring to FIG. 1, a system 1 (hereinafter referred to as a "diagnostic system") for diagnosing a battery management system (BMS) is connected to a battery system including the BMS to measure a voltage at a connected node, diagnose a state of the BMS based on the measured voltage value, and output a screen displaying the diagnosed result. The diagnostic system 1 may include a measuring device 100 and an output device 200.

The measuring device 100 may measure a voltage at a node ND, and may transmit a result of diagnosing the state of the BMS based on the measured voltage to the output device 200. Here, the node ND may be a node on a wire connected to the BMS. The measuring device 100 may include a voltage measurer 110, a controller 120, and a communicator 130.

The voltage measurer 110 may measure a voltage from the node ND, and may generate a signal (hereinafter referred to as a "voltage signal") representing the measured voltage to transmit it to the controller 120.

The controller 120 may derive a voltage value based on the voltage signal received from the voltage measurer 110. Deriving the voltage value may comprise the step of outputting a voltage value that has a positive level at the times when a voltage signal is measured at the node ND. The controller 120 may determine whether the voltage value reaches a trigger level indicating a predetermined reference voltage during a predetermined measuring period, may count the number of times the voltage value reaches the trigger level (for example, determine the number of times the voltage value crosses the trigger level), and may determine a state of the BMS based on a count result for a predetermined measuring period. For example, the predetermined measuring period may be 10 seconds.

The state of the BMS may be either a normal state indicating a normally operating state or an abnormal state indicating a non-normal operating state. The normal state may be a normal state of one of a plurality of power modes according to a cycle in which the BMS measures a voltage, a temperature, a current, and the like of the battery. Hereinafter, for convenience of description, it is assumed that the plurality of power modes are modes according to a cycle in which the BMS measures the temperature of the battery through a thermistor.

In the embodiment, the plurality of power modes may include a first mode and a second mode. The first mode is a mode in which the BMS periodically measures the temperature through the thermistor every first period. That is, in the first mode, the BMS may repeat an operation of measuring the temperature through the thermistor at a time interval of the first period. The first mode may be referred to as an active or normal mode. The second mode is a mode in which the BMS periodically measures the temperature through the thermistor every second period. That is, in the second mode, the BMS may repeat an operation of measuring the temperature through the thermistor at a time interval of the second period. The second mode may be referred to as a sleep or standby mode. Here, the second period may be longer than the first period. For example, the first period may be 1 second, and the second period may be 10 seconds.

In the embodiment, the controller 120 may determine the state of the BMS as a normal state in the first mode, a normal state in the second mode, or an abnormal state, based on the count result.

For example, the controller 120 may determine a first range in which a value obtained by dividing a predetermined measuring period by the first period and multiplied by 2 is taken as a minimum value, and a value obtained by adding 2 to the minimum value is taken as a maximum value; and when the count result during the predetermined measuring period is within the first range, the controller 120 may determine the state of the BMS as a normal state in the first mode in which the voltage measuring cycle is the first period. The controller 120 may determine a second range in which a value obtained by dividing a predetermined measuring period by the second period and multiplied by 2 is taken as a minimum value, and a value obtained by adding 2 to the minimum value is taken as a maximum value; and when the count result during the predetermined measuring period is within the second range, the controller 120 may determine the state of the BMS as a normal state in the second mode in which the voltage measuring cycle is the second period. The controller 120 may determine the state of the BMS as the abnormal state when the count result during the predetermined measuring period is not within the first range or the second range.

The communicator 130 may transmit and receive signals to and from an external device such as the output device 200 through wired or wireless communication with the external device.

The output device 200 may output a diagnosed result based on the signal received from the measurer 100. The output device 200 may include a display that visually outputs the diagnosed result. In addition, the output device may include a speaker that outputs the diagnosed result as sound. The diagnosed result may include information indicating the number of times the voltage value measured by the measurer 100 reaches the trigger level and/or the state of the BMS.

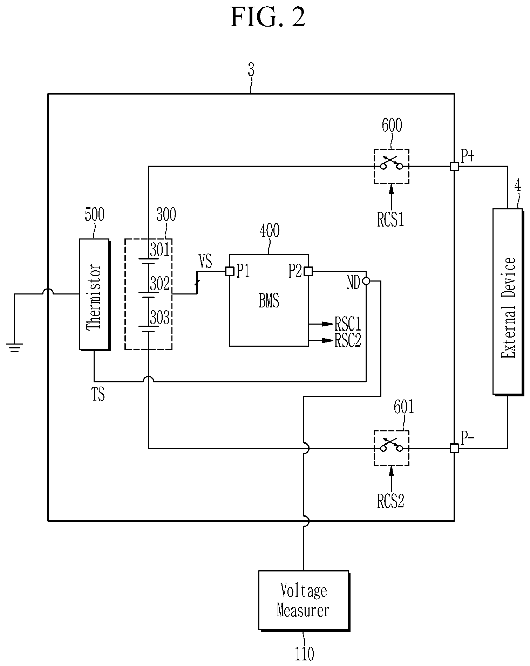

Hereinafter, a state in which the diagnostic system 1 is connected to a wire connected to a BMS will be described with reference to FIG. 2.

FIG. 2 is a block diagram for explaining a battery system to which the voltage measurer of FIG. 1 is connected.

A battery system 3 may include a battery pack 300, a BMS 400, a thermistor 500, and relays 600 and 601.

An external device 4 may include a load such as an inverter and a converter, and/or a charging device. When the external device 4 is a charging device, respective ends of the battery system 3 are connected to the charging device, so that the battery system 3 may be charged by receiving power from the charging device. When the external device 4 is a load, respective ends of the battery system 3 are connected to the load, so that power supplied by the battery pack 300 may be discharged through the load.

The battery pack 300 may generate a voltage measuring signal VS indicating a cell voltage of each of a plurality of battery cells 301 to 303 to transmit it to the BMS 400. The BMS 400 may obtain a voltage measuring signal VS from the battery pack 300 through a pin P1.

The battery pack 300 may include a plurality of battery cells 301 to 303. Although FIG. 2 illustrates that the number of a plurality of battery cells 301 to 303 is three, the present disclosure is not limited thereto, and the battery pack 300 may be implemented with 2 or more battery cells connected in series, a plurality of battery cells in which two or more battery cells connected in parallel are connected in series, or two or more battery cells connected in parallel.

The thermistor 500 may sense the pack temperature of the battery pack 300 to generate a temperature measuring signal TS, and may transmit the temperature measuring signal TS to the BMS 400. Here, the temperature measuring signal TS may indicate a voltage value determined according to the measured temperature. One end of the thermistor 500 is connected to pin P2, and the other end of the thermistor 500 is connected to the ground. The BMS 400 may obtain the temperature measuring signal TS from the thermistor 500 through a pin P2.

One end of each of the relays 600 and 601 is connected to the battery pack 300, and the other end of each of the relays 600 and 601 is connected to at least one component of an external device 4. Closing and opening of the relays 600 and 601 may be controlled according to relay control signals RCS1 and RCS2 supplied from the BMS 400.

The node ND may be disposed on a wire connected between one end of the thermistor 500 and the pin P2. The voltage measurer 110 may be electrically connected to the node ND to measure the voltage of the node ND, and may generate a voltage signal representing the measured voltage.

The BMS 400 may periodically receive the temperature measuring signal TS according to a predetermined measuring cycle. The predetermined measuring cycle may be determined according to the state of the BMS 400. The predetermined measuring cycle may include the first period in the first mode, the second period in the second mode, and the like.

When the BMS 400 performs an operation of reading the temperature measuring signal TS from the thermistor 500 through the pin P2, the voltage of the node ND may be changed. The voltage measurer 110 may measure the changed voltage of the node ND.

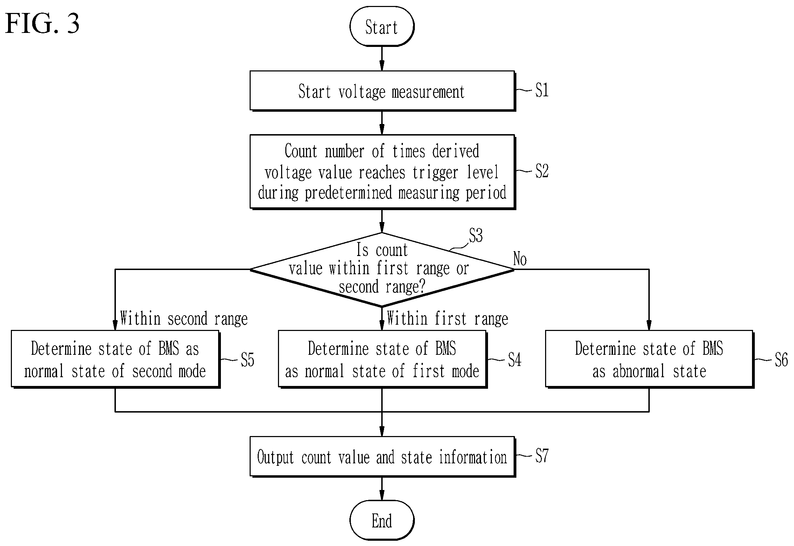

Hereinafter, a method of diagnosing the state of the BMS based on the voltage measured by the diagnostic system 1 will be described with reference to FIG. 3 to FIG. 5.

FIG. 3 illustrates a flowchart of a diagnostic method according to an embodiment.

The voltage measurer 110 may start measuring the voltage from the node ND (S1), and may transmit the measured voltage signal to the controller 120.

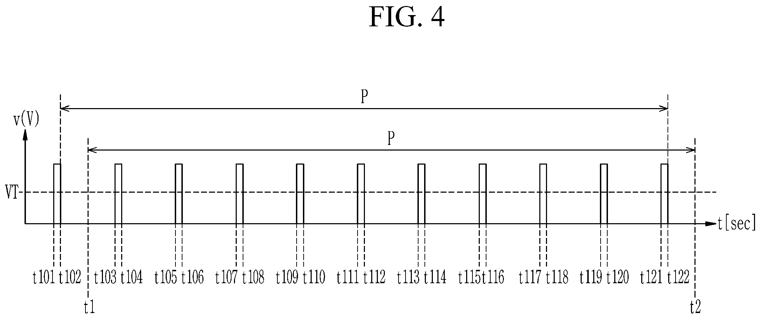

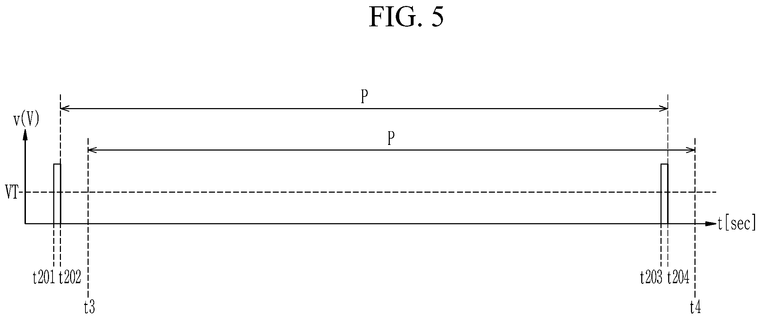

The controller 120 may derive a voltage value based on the voltage signal and count the number of times the derived voltage value reaches the trigger level during a predetermined measuring period (S2). The controller 120 may generate a value indicating the number of times the trigger level is reached (hereinafter referred to as a "count value"). Hereinafter, steps S2 and S3 will be described with reference to FIG. 4 and FIG. 5.

FIG. 4 and FIG. 5 illustrate waveform diagrams of the voltage signals derived by the controller in step S2.

The voltage signal may reach a trigger level VT once or more during a predetermined measuring period. The trigger level VT may indicate an arbitrary voltage value among values between highest and lowest values of the voltage values measured during the predetermined measuring period.

According to the waveform diagram shown in FIG. 4, the controller 120 may count the number of times a voltage value v reaches the trigger level VT from a start time point t1 of a predetermined measuring period P to an end time point t2 of the measuring period P. The voltage value v reaches the trigger level VT at time points t103, t104, t105, t106, t107, t108, t109, t110, t111, and t112. Accordingly, referring to FIG. 4, the count value is 20 times.

In addition, according to the waveform diagram shown in FIG. 5, the controller 120 may count the number of times the voltage value v reaches the trigger level VT from a start time point t3 of the measuring period P to an end time point t4 of the measuring period P. The voltage value v reaches the trigger level VT at time points t203 and t204. Accordingly, referring to FIG. 5, the count value is 2 times.

When the predetermined measuring period P ends, the controller 120 may determine whether the count value is within the first range or the second range (S3). In the controller 120, information of the first and second periods indicating the measuring cycle of each of the first and second modes may be previously stored. Alternatively, the controller 120 may receive information indicating the first and second periods from the BMS 400 through the communicator 130.

The first range may be a range in which the BMS 400 normally operates corresponding to a case in which the measuring cycle of the BMS 400 is the first period. The first range may be, as shown in Equation 1 below, a range equal to or greater than a value obtained by dividing the measuring period P by the first period and multiplied by 2 and less than a value obtained by adding 2 to a value obtained by dividing the measuring period P by the first period and multiplied by 2.

(Equation 1)

$$\frac{P}{T1}*2 \ \leq Count \ <\frac{P}{T1}*2+2$$

Here, P is a measuring period for counting the number of times, T1 is the first period corresponding to the first mode of the BMS 400, and Count is a value counted by the controller 120. Units of P and T1 may both be seconds.

For example, when the first period T1 is 1 second and the measuring period P is 10 seconds, the first range is a range in which the count value is 20 or more and 22 or less. In the example of FIG. 4, since the count value is 20 times, the controller 120 may determine that the count value is within the first range.

The second range may be a range in which the BMS 400 normally operates corresponding to a case in which the measuring cycle of the BMS 400 is the second period. As shown in Equation 2 below, the second range may be a range equal to or greater than a value obtained by dividing the measuring period P by the second period and multiplied by 2 and less than a value obtained by adding 2 to a value obtained by dividing the measuring period P by the second period and multiplied by 2.

(Equation 2)

$$\frac{P}{T2} * 2 \ \leq Count \ < \frac{P}{T2} * 2 + 2$$

Here, P is a measuring period for counting the number of times, T2 is the second period corresponding to the first mode of the BMS 400, and Count is a value counted by the controller 120. Units of P and T2 may both be seconds.

For example, when the second period T2 is 10 seconds and the measuring period P is 10 seconds, the second range is a range in which the count value is 2 or more and 4 or less. In the example of FIG. 5, since the count value is 2 times, the controller 120 may determine that the count value is within the second range.

The reason that the value obtained by adding 2 to the minimum value in each of the first and second ranges is determined as the maximum value is because when the voltage value at the start time point and/or the end time point of the measuring period P is the same as the trigger level, the count value may exceed a value obtained by dividing the measuring period P by the first or second period T1 or T2 even when the BMS 400 is in a normal state.

For example, in FIG. 4, it is assumed that the start time point of the measuring period P is t102 and the end time point of the measuring period P is t122. The voltage value reaches the trigger level VT at time points t102, t103, t104, t105, t106, t107, t108, t109, t110, t111, and t112. Accordingly, the count value is 21 times.

In addition, for example, in FIG. 5, it is assumed that the start time point of the measuring period P is t202 and the end time point of the measuring period P is t204. The voltage value reaches the trigger level VT at time points t202, t203, and t204. Accordingly, the count value is 3 times.

When the count value is within the first range, the controller 120 may determine the state of the BMS 400 as the normal state of the first mode (S4). When the count value is within the second range, the controller 120 may determine the state of the BMS 400 as the normal state of the second mode (S5). When the count value is not within the first and second ranges, the controller 120 may determine the state of the BMS 400 as the abnormal state (S6).

A voltage value being above the trigger level may indicate that the BMS is performing a measurement. In the normal state in which the BMS 400 normally operates, since the measuring cycle is the first or second period, the count value is within the first or second range. When the count value is not within the first and second ranges, since the measuring cycle of the BMS 400 is different from the first or second period, the controller 120 may determine that the BMS 400 is in an abnormal state.

In FIG. 3, the state in which the BMS 400 normally operates is illustrated as a normal state of one of the first mode and the second mode, but the present disclosure is not limited thereto. The normal state of the BMS 400 may include respective normal states of two or more modes in which the BMS 400 operates at different cycles.

The controller 120 may determine the state of the BMS 400 through one of steps S4 to S6 and generate a signal indicating the determined state of the BMS 400 (hereinafter referred to as a "BMS state signal"). The BMS state signal may include information indicating a count value. The communicator 130 may transmit the BMS state signal to the output device 200.

The output device 200 may receive the BMS state signal. The output device 200 may output a diagnostic result including a count value and information representing a state of the BMS 400 based on the BMS state signal (S7). The output device 200 may visually output the diagnostic result through a display. The output device 200 may provide a screen displaying the diagnostic result through an application and the like installed in the output device 200.

A user may check the state of the BMS 400 through the output device 200 and, when the BMS 400 is in an abnormal state, may take countermeasures for the abnormal state.

While the embodiment of the present disclosure has been described in connection with what is presently considered to be practical embodiments, it is to be understood that the disclosure is not limited to the disclosed embodiments, but, on the contrary, is intended to cover various modifications included within the scope of the appended claims.

**<Description of symbols>**

1: diagnostic system
100: measuring device
110: voltage measurer
120: controller
130: communicator
200: output device

3: battery system
300: battery pack
301, 302, 303: battery cell
400: battery management system (BMS)
500: thermistor
600, 601: relay
4: external device

**Claims**

1. A measuring device (100), comprising:

   a voltage measurer (110) configured to measure a voltage from a node (ND) on a wire connected to a battery management system (BMS); and
   a controller (120) configured to receive the measured voltage signal from the voltage measurer to derive a voltage value, to count the number of times the voltage value reaches a reference voltage during a measuring period, and to determine a state of the BMS as one of a normal state of a first mode, a normal state of a second mode, and an abnormal state based on the number of times.

2. The measuring device of claim 1, wherein

   the wire is a wire connected to one end of a thermistor (500),
   the first mode is a power mode in which the BMS measures a temperature from the thermistor at a cycle of a first period, and
   the second mode is a power mode in which the BMS measures the temperature from the thermistor at a cycle of a second period longer than the first period.

3. The measuring device of claim 2, wherein
   when the number of times is within a first range in which a value obtained by dividing the measuring period by the first period and multiplied by 2 is a minimum value and a value obtained by adding 2 to the minimum value is a maximum value, the controller determines the state of the BMS as the normal state of the first mode.

4. The measuring device of claim 3, wherein
   when the number of times is within a second range in which a value obtained by dividing the measuring period by the second period and multiplied by 2 is a minimum value and a value obtained by adding 2 to the minimum value is a maximum value, the controller determines the state of the BMS as the normal state of the second mode.

5. The measuring device of claim 4, wherein
   the controller determines the state of the BMS as the abnormal state when the number is not within the first and second ranges.

6. A diagnostic system, comprising:

   a measuring device according to any one of claims 1 - 5; and
   an output device (200) that receives a signal indicating the state of the BMS from the measuring device, and outputs a diagnostic result including the state of the BMS based on the signal indicating the state of the BMS.

7. The diagnostic system of claim 6, wherein
   the output device includes a display that visually outputs the diagnostic result.

8. A diagnostic method, comprising:

   measuring a voltage from a node (ND) on a wire connected to a battery management system (BMS);
   deriving a voltage value based on the measured voltage and counting the number of times the voltage value reaches a reference voltage during a measuring period;
   determining whether the number of times is within a first or second range; and
   determining the state of the BMS as one of a normal state of a first mode, a normal state of a second mode, and an abnormal state based on the determined result.

9. The diagnostic method of claim 8, wherein

the wire is a wire connected to one end of a thermistor (500),
the first mode is a power mode in which the BMS measures a temperature from the thermistor at a cycle of a first period, and
the second mode is a power mode in which the BMS measures the temperature from the thermistor at a cycle of a second period longer than the first period.

10. The diagnostic method of claim 9, wherein
the first range is a range in which a value obtained by dividing the measuring period by the first period and multiplied by 2 is a minimum value and a value obtained by adding 2 to the minimum value is a maximum value.

11. The diagnostic method of claim 10, wherein

the determining of the state of the BMS as one of the normal state of the first mode, the normal state of the second mode, and the abnormal state includes
determining, when the number of times is within the first range, the state of the BMS as the normal state of the first mode.

12. The diagnostic method of any one of claims 9 - 11, wherein
the second range is a range in which a value obtained by dividing the measuring period by the second period and multiplied by 2 is a minimum value and a value obtained by adding 2 to the minimum value is a maximum value.

13. The diagnostic method of claim 12, wherein

the determining of the state of the BMS as one of the normal state of the first mode, the normal state of the second mode, and the abnormal state includes
determining, when the number of times is within the second range, the state of the BMS as the normal state of the second mode.

14. The diagnostic method of any one of claims 8 - 13, wherein

the determining of the state of the BMS as one of the normal state of the first mode, the normal state of the second mode, and the abnormal state includes
determining the state of the BMS as the abnormal state when the number is not within the first or second ranges.

15. The diagnostic method of claim 8 - 14, further comprising
outputting a diagnostic result including the state of the BMS determined as one of the normal state of the first mode, the normal state of the second mode, and the abnormal state wherein, optionally, the outputting of the diagnostic result includes visually outputting the state of the BMS and the number of times through a display.

**Patentansprüche**

1. Messvorrichtung (100), umfassend:

einen Spannungsmesser (110), der dafür konfiguriert ist, eine Spannung von einem Knoten (ND) auf einem Draht, der mit einem Batteriemanagementsystem (BMS) verbunden ist, zu messen; und
eine Steuerungseinrichtung (120), die dafür konfiguriert ist, das gemessene Spannungssignal von dem Spannungsmesser zu empfangen, um einen Spannungswert abzuleiten, zu zählen, wie viele Male der Spannungswert während eines Messzeitabschnitts eine Referenzspannung erreicht, und auf der Grundlage der Anzahl der Male einen Zustand des BMS als einen von einem normalen Zustand einer ersten Betriebsart, einem normalen Zustand einer zweiten Betriebsart und einem anormalen Zustand zu bestimmen.

2. Messvorrichtung nach Anspruch 1, wobei:

der Draht ein Draht ist, der mit einem Ende eines Thermistors (500) verbunden ist,

die erste Betriebsart eine Leistungsbetriebsart ist, in der das BMS eine Temperatur von dem Thermistor in einem Zyklus eines ersten Zeitabschnitts misst, und

die zweite Betriebsart eine Leistungsbetriebsart ist, in der das BMS die Temperatur von dem Thermistor bei einem Zyklus eines zweiten Zeitabschnitts misst, der länger als der erste Zeitabschnitt ist.

3. Messvorrichtung nach Anspruch 2, wobei:
wenn die Anzahl der Male innerhalb eines ersten Bereichs liegt, in dem ein Wert, der durch Dividieren des Messzeitabschnitts durch den ersten Zeitabschnitt und Multiplizieren mit 2 erlangt wird, ein Mindestwert ist und ein Wert, der durch Addieren von 2 zu dem Mindestwert erlangt wird, ein Höchstwert ist, die Steuerungseinrichtung den Zustand des BMS als den normalen Zustand der ersten Betriebsart bestimmt.

4. Messvorrichtung nach Anspruch 3, wobei:
wenn die Anzahl der Male innerhalb eines zweiten Bereichs liegt, in dem ein Wert, der durch Dividieren des Messzeitabschnitts durch den zweiten Zeitabschnitt und Multiplizieren mit 2 erlangt wird, ein Mindestwert ist und ein Wert, der durch Addieren von 2 zum Mindestwert erlangt wird, ein Höchstwert ist, die Steuerungseinrichtung den Zustand des BMS als den normalen Zustand der zweiten Betriebsart bestimmt.

5. Messvorrichtung nach Anspruch 4, wobei:
die Steuerungseinrichtung den Zustand des BMS als den anormalen Zustand bestimmt, wenn die Zahl nicht innerhalb des ersten und zweiten Bereichs liegt.

6. Diagnosesystem, umfassend:

eine Messvorrichtung nach einem der Ansprüche 1 bis 5; und
eine Ausgabevorrichtung (200), die ein Signal, das den Zustand des BMS angibt, von der Messvorrichtung empfängt und ein Diagnoseergebnis ausgibt, das den Zustand des BMS auf der Grundlage des Signals, das den Zustand des BMS angibt, einschließt.

7. Diagnosesystem nach Anspruch 6, wobei:
die Ausgabevorrichtung eine Anzeige einschließt, die das Diagnoseergebnis visuell ausgibt.

8. Diagnoseverfahren, umfassend:

Messen einer Spannung von einem Knoten (ND) auf einem Draht, der mit einem Batteriemanagementsystem (BMS) verbunden ist;
Ableiten eines Spannungswertes auf der Grundlage der gemessenen Spannung und Zählen der Anzahl von Malen, die der Spannungswert eine Referenzspannung während eines Messzeitabschnitts erreicht;
Bestimmen, ob die Anzahl von Malen innerhalb eines ersten oder zweiten Bereichs liegt; und
Bestimmen des Zustands des BMS als einen von einem normalen Zustand einer ersten Betriebsart, einem normalen Zustand einer zweiten Betriebsart und einem anormalen Zustand auf der Grundlage des bestimmten Ergebnisses.

9. Diagnoseverfahren nach Anspruch 8, wobei:

der Draht ein Draht ist, der mit einem Ende eines Thermistors (500) verbunden ist,
die erste Betriebsart eine Leistungsbetriebsart ist, in der das BMS eine Temperatur von dem Thermistor bei einem Zyklus eines ersten Zeitabschnitts misst, und
die zweite Betriebsart eine Leistungsbetriebsart ist, in der das BMS die Temperatur von dem Thermistor bei einem Zyklus eines zweiten Zeitabschnitts misst, der länger als der erste Zeitabschnitt ist.

10. Diagnoseverfahren nach Anspruch 9, wobei:
der erste Bereich ein Bereich ist, in dem ein Wert, der durch Dividieren des Messzeitabschnitts durch den ersten Zeitabschnitt und Multiplizieren mit 2 erlangt wird, ein Mindestwert ist und ein Wert, der durch Addieren von 2 zum Mindestwert erlangt wird, ein Höchstwert ist.

11. Diagnoseverfahren nach Anspruch 10, wobei:
das Bestimmen des Zustands des BMS als einen des normalen Zustands der ersten Betriebsart, des normalen Zustands der zweiten Betriebsart und des anormalen Zustands einschließt:
Bestimmen des Zustands des BMS als den normalen Zustand der ersten Betriebsart, wenn die Anzahl der Male innerhalb des ersten Bereichs liegt.

12. Diagnoseverfahren nach einem der Ansprüche 9 bis 11, wobei:
der zweite Bereich ein Bereich ist, in dem ein Wert, der durch Dividieren des Messzeitabschnitts durch den zweiten Zeitabschnitt und Multiplizieren mit 2 erlangt wird, ein Mindestwert ist und ein Wert, der durch Addieren von 2 zum Mindestwert erlangt wird, ein Höchstwert ist.

13. Diagnoseverfahren nach Anspruch 12, wobei:
das Bestimmen des Zustands des BMS als einen des normalen Zustands der ersten Betriebsart, des normalen Zustands der zweiten Betriebsart und des anormalen Zustands einschließt:
Bestimmen des Zustands des BMS als den normalen Zustand der zweiten Betriebsart, wenn die Anzahl der Male innerhalb des zweiten Bereichs liegt.

14. Diagnoseverfahren nach einem der Ansprüche 8 bis 13, wobei:
das Bestimmen des Zustands des BMS als einen des normalen Zustands der ersten Betriebsart, des normalen Zustands der zweiten Betriebsart und des anormalen Zustands einschließt:
Bestimmen des Zustands des BMS als den anormalen Zustand, wenn die Anzahl nicht innerhalb des ersten oder zweiten Bereichs liegt.

15. Diagnoseverfahren nach Anspruch 8 bis 14, ferner umfassend:
Ausgeben eines Diagnoseergebnisses, das den Zustand des BMS einschließt, der als einer des normalen Zustands der ersten Betriebsart, des normalen Zustands der zweiten Betriebsart und des anormalen Zustands bestimmt wurde, wobei optional das Ausgeben des Diagnoseergebnisses einschließt: visuelles Ausgeben des Zustands des BMS und der Anzahl der Male über eine Anzeige.

## Revendications

1. Dispositif de mesure (100) comprenant :

un voltmètre (110) configuré pour mesurer une tension depuis un nœud (ND) sur un fil raccordé à un système de gestion de batterie (BMS) ; et
un système de commande (120) configuré pour recevoir le signal de tension mesuré par le voltmètre pour obtenir une valeur de tension, pour compter le nombre de fois où la valeur de tension atteint une tension de référence pendant une période de mesure, et pour déterminer un état du BMS comme l'un parmi un état normal d'un premier mode, un état normal d'un second mode, et un état anormal sur la base du nombre de fois.

2. Dispositif de mesure selon la revendication 1, dans lequel

le fil est un fil connecté à une extrémité d'une thermistance (500),
le premier mode est un mode d'alimentation dans lequel le BMS mesure une température de la thermistance à un cycle d'une première période, et
le second mode est un mode d'alimentation dans lequel le BMS mesure la température de la thermistance à un cycle d'une seconde période plus longue que la première période.

3. Dispositif de mesure selon la revendication 2, dans lequel
quand le nombre de fois est dans une première plage dans laquelle une valeur obtenue en divisant la période de mesure par la première période et multipliée par 2 est une valeur minimale et une valeur obtenue en ajoutant 2 à la valeur minimale est une valeur maximale, le système de commande détermine l'état du BMS comme étant l'état normal du premier mode.

4. Dispositif de mesure selon la revendication 3, dans lequel
quand le nombre de fois est dans une seconde plage dans laquelle une valeur obtenue en divisant la période de mesure par la seconde période et multipliée par 2 est une valeur minimale et une valeur obtenue en ajoutant 2 à la valeur minimale est une valeur maximale, le système de commande détermine l'état du BMS comme étant l'état normal du second mode.

**5.** Dispositif de mesure selon la revendication 4, dans lequel
le système de commande détermine l'état du BMS comme étant l'état anormal lorsque le nombre n'est pas dans la première et la seconde plage.

**6.** Système de diagnostic comprenant :

un dispositif de mesure selon l'une quelconque des revendications 1 à 5 ; et
un dispositif de sortie (200) qui reçoit un signal indiquant l'état du BMS depuis le dispositif de mesure, et émet un résultat de diagnostic incluant l'état du BMS sur la base du signal indiquant l'état du BMS.

**7.** Système de diagnostic selon la revendication 6, dans lequel
le dispositif de sortie inclut un écran qui émet visuellement le résultat du diagnostic.

**8.** Procédé de diagnostic comprenant :

la mesure d'une tension depuis un nœud (ND) sur un fil connecté à un système de gestion de batterie (BMS) ;
l'obtention d'une valeur de tension sur la base de la tension mesurée et le décompte du nombre de fois où la valeur de tension atteint une tension de référence pendant une période de mesure ;
la détermination si le nombre de fois est dans une première ou une seconde plage ; et
la détermination de l'état du BMS comme l'un parmi un état normal d'un premier mode, un état normal d'un second mode, et un état anormal sur la base du résultat déterminé.

**9.** Procédé de diagnostic selon la revendication 8, dans lequel

le fil est un fil connecté à une extrémité d'une thermistance (500),
le premier mode est un mode d'alimentation dans lequel le BMS mesure une température de la thermistance à un cycle d'une première période, et
le second mode est un mode d'alimentation dans lequel le BMS mesure la température de la thermistance à un cycle d'une seconde période plus longue que la première période.

**10.** Procédé de diagnostic selon la revendication 9, dans lequel
la première plage est une plage dans laquelle une valeur obtenue en divisant la période de mesure par la première période et multipliée par 2 est une valeur minimale et une valeur obtenue en ajoutant 2 à la valeur minimale est une valeur maximale.

**11.** Procédé de diagnostic selon la revendication 10, dans lequel
la détermination de l'état du BMS comme l'un parmi l'état normal du premier mode, l'état normal du second mode, et l'état anormal inclut :
la détermination, quand le nombre de fois est dans la première plage, de l'état du BMS comme étant l'état normal du premier mode.

**12.** Procédé de diagnostic selon l'une quelconque des revendications 9 à 11, dans lequel
la seconde plage est une plage dans laquelle une valeur obtenue en divisant la période de mesure par la seconde période et multipliée par 2 est une valeur minimale et une valeur obtenue en ajoutant 2 à la valeur minimale est une valeur maximale.

**13.** Procédé de diagnostic selon la revendication 12, dans lequel

la détermination de l'état du BMS comme l'un parmi l'état normal du premier mode, l'état normal du second mode, et l'état anormal inclut :
la détermination, quand le nombre de fois est dans la seconde plage, de l'état du BMS comme étant l'état normal du second mode.

**14.** Procédé de diagnostic selon l'une quelconque des revendications 8 à 13, dans lequel
la détermination de l'état du BMS comme l'un parmi l'état normal du premier mode, l'état normal du second mode, et l'état anormal inclut :
la détermination de l'état du BMS comme étant l'état anormal quand le nombre n'est pas dans la première ou la seconde plage.

**15.** Procédé de diagnostic selon les revendications 8 à 14, comprenant en outre :

l'émission d'un résultat de diagnostic incluant l'état du BMS déterminé comme un parmi l'état normal du premier mode, l'état normal du second mode, et l'état anormal, dans lequel, facultativement, l'émission du résultat de diagnostic inclut l'émission visuelle de l'état du BMS et du nombre de fois par le biais d'un écran.

# FIG. 1

# FIG. 2

**FIG. 3**

Start

Start voltage measurement — S1

Count number of times derived
voltage value reaches trigger level
during predetermined measuring period — S2

Is count
value within first range or
second range? — S3

No

Within second range

Within first range

Determine state of BMS as
normal state of second mode — S5

Determine state of BMS
as normal state of first mode — S4

Determine state of BMS
as abnormal state — S6

Output count value and state information — S7

End

# FIG. 4

# FIG. 5

**REFERENCES CITED IN THE DESCRIPTION**

**Patent documents cited in the description**

- KR 20200107813 A
- US 2020200805 A1
- CN 109541489 A
- KR 20190042340
- US 2016291114 A1